# EUROPEAN PATENT APPLICATION

(11) **EP 3 998 485 A1**
(43) Date of publication of application: **18.05.2022**
(21) Application number: 20836754.0
(22) Date of filing: 28.05.2020
(51) Int. Cl.: G01R 31/00, G01R 19/00, G01R 15/18, G01R 11/04

(54) **POWER MONITORING DEVICE**

(30) Priority: 09.07.2019 CN 201910614312
(71) Applicant: Jiangsu Sfere Electric Co., Ltd, Wuxi, Jiangsu 214437 (CN)
(72) Inventor: ZHANG, Fengchu, Wuxi, Jiangsu 214437 (CN); GU, Yigang, Wuxi, Jiangsu 214437 (CN); XU, Wenzhuan, Wuxi, Jiangsu 214437 (CN); ZHU, Junchang, Wuxi, Jiangsu 214437 (CN)
(74) Representative: Lang, Christian
(86) International application number: PCT/CN2020/092819
(87) International publication number: WO 2021/004184

(57) **Abstract**

In the power monitoring device of the present invention, there is a plurality of tube bodies on the inner surface of a first housing, there is a lead seal snap on the outside of the top of the first housing; on the top of the inner side of a second housing is a snap groove for fixing and positioning a second circuit board; the outer surface of the second housing has a guide groove for installing a protective cover; on the outer surface of the second housing is a plurality of through-holes corresponding to the tube bodies; the top of the protective cover is provided with a lead seal ring, and a guide rib is provided on the inner side of the protective cover; the first and second circuit boards are electrically connected by means of connectors; the first and second circuit boards are vertical relative to each other; a transformer coil is installed on the first circuit board; the transformer coil is electrically connected to the first circuit board; the first circuit board is provided with through-holes corresponding one-to-one to the tube bodies; the through-holes of the first circuit board and the transformer coil are sequentially sleeved on the corresponding tube bodies; the first circuit board is installed on the inner surface of the first housing; the second circuit board is installed on the inner side face of the first housing; the second and the first housing are fixedly connected; the guide rib is inserted into the guide groove; the lead seal ring and the lead seal snap are snap-connected together.

## Description

### FIELD OF TECHNOLOGY

The present invention relates to the technical field of power monitoring, in particular to a power monitoring apparatus.

### BACKGROUND

In recent years, energy saving and consumption reduction have been implemented as a major national policy in China, and the acquisition of electric energy data is the main source of energy data analysis. In order to achieve refined energy management and reduce costs and increase efficiency for enterprises, it is necessary to realize real-time monitoring of power data for each power supply circuit or device. The existing monitoring solutions are generally only applied to the main power supply circuit monitoring due to the volume and cost, and can not achieve the monitoring of each power supply branch.

### SUMMARY

Aiming at the problems and defects existing in the prior art, the present invention provides a novel power monitoring apparatus.

The present invention solves the technical problem through the following technical solution:
the present invention provides a power monitoring apparatus, which includes a first housing, a second housing, a protective cover, a plurality of transformer coils, a first circuit board and a second circuit board, wherein
an inner surface of the first housing is provided with a plurality of tube bodies arranged in a single line, and an outside of a top of the first housing is provided with a lead seal snap;
a top of an inner side of the second housing is provided with a snap groove for fixing and positioning the second circuit board, an outer surface of the second housing is provided with a guide groove for installing the protective cover, and the outer surface of the second housing is provided with a plurality of through-holes one-to-one corresponding to the tube bodies for threading cables;
a top of the protective cover is provided with a lead seal ring mated with the lead seal snap, and an inner side of the protective cover is provided with a guide rib mated with a guide groove; and
the first circuit board and the second circuit board are electrically connected through a connector, the first circuit board and the second circuit board are installed vertically to each other, a transformer coil is installed on the first circuit board, the transformer coil is electrically connected to the first circuit board through a connecting line, the first circuit board is provided with the through-holes one-to-one corresponding to the tube bodies, the through-holes of the first circuit board and the transformer coil are sequentially sleeved on the corresponding tube bodies, the first circuit board is installed on the inner surface of the first housing, the second circuit board is installed on an inner side surface of the first housing, the second housing and the first housing are fixedly connected, the guide rib is inserted into the guide groove, the lead seal ring is sleeved on the lead seal snap, and the lead seal ring and the lead seal snap are snap-connected together.

Preferably, an outer ring of the tube body is provided with support ribs for supporting the transformer coils along a circumferential direction.

Preferably, a top of an inner wall of the first housing and upper portions of left and right sides of the inner wall are provided with the guide ribs for guiding the installed second circuit board.

Preferably, four support ribs for supporting the first circuit board are disposed at a bottom of the inner wall of the first housing.

Preferably, four buckles are disposed at an opening of the inner wall of the first housing, and four buckle grooves one-to-one corresponding to the buckles are disposed on a side edge of the second housing, and the buckles and corresponding buckle grooves are snap-connected.

Preferably, a bottom of an inner side of the second housing is provided with a support post for supporting the first circuit board.

Preferably, a tie buckle is disposed on an outer side surface of the second housing and between two adjacent through-holes.

Preferably, the second circuit board is provided with two identical multi-port sockets and one miniature USB interface.

Preferably, the lead seal ring is sleeved on the lead seal snap to form a lead seal structure, to allow a lead seal process to be implemented.

Preferably, the lead seal structure has a certain distance from an assembly position of the first housing and the second housing, to increase a static discharge distance inside and outside the power monitoring apparatus.

On the basis of conforming to the common knowledge in the art, the above preferred conditions can be arbitrarily combined to obtain the preferred examples of the present invention.

The positive progressive effect of the present invention lies in:
the power monitoring apparatus of the present invention is used for monitoring power parameters of a miniature circuit breaker end, has small volume and a same width dimension as a three-phase miniature circuit breaker, can be used in a control terminal where a plurality of miniature circuit breakers are densely arranged, and can be normally used even if a plurality of miniature circuit breakers are closely arranged at a zero distance; when a plurality of electric quantity monitoring modules are arranged, the multi-port socket on both sides of the front face are connected in series through connecting lines with corresponding plugs, so that a large amount of wiring workload and arrangement space are saved without using tools for wiring; the miniature USB interface in the middle of the front face can realize online programming, which is convenient and quick; after the wiring is completed, the protective cover can be used to cover the connecting line end and the miniature USB interface, and the lead seal can be implemented through the lead seal ring and the lead seal snap, to prevent plugging and unplugging the connecting line and changing the firmware, and the protective cover increases the static discharge distance inside and outside the power monitoring apparatus, the first circuit board is installed at the bottom of the first housing, there is an enough static discharge distance to an assembling clearance between the first housing and the second housing, which improves the safety; and the electric quantity monitoring module can be fixed on the cable through the front tie buckle by using fixing tools such as tie bands, and the fixing pieces are convenient to obtain, low in cost and easy to operate during use.

The present invention takes into account both volume and cost, can realize the monitoring of power parameters at the miniature circuit breaker end, simplifies installation and reduces wiring workload, and the width dimension of the power monitoring apparatus is the same as that of the miniature circuit breaker.

### BRIEF DESCRIPTION OF THE DRAWINGS

Figs. 1(a)-(b) are structural schematic diagrams of a first housing;
Figs. 2(a)-(b) are structural schematic diagrams of a second housing;
Fig. 3 is a structural schematic diagram of a protective cover;
Fig. 4 is a schematic diagram of an embodiment of the present invention;
Figs. 5(a)-(e) are schematic diagrams of an assembly process of the embodiment of the present invention;
Fig. 6 is a schematic front view of the power monitoring apparatus after installation is completed;
Fig. 7(a) is an A-A section view in Fig. 6 and a schematic diagram of an installing position of a first circuit board;
Fig. 7(b) is the A-A sectional view in Fig. 6 and a schematic diagram of increasing a static discharge distance by the protective cover;
Figs. 8(a)-(c) are schematic diagrams of a wiring process of the power monitoring apparatus;
Fig. 9 is a schematic diagram of a series expansion of a plurality of miniature circuit breakers according to the embodiment of the present invention;
Fig. 10 is a partially enlarged schematic diagram of a lead seal process; and
Fig. 11 is a schematic diagram of fixing the power monitoring apparatus to cables.

### DETAILED DESCRIPTION OF THE EMBODIMENTS

To make the objects, technical solutions and advantages of the present invention more clear, the technical aspects of the embodiments of the present invention will be clearly and completely described below in conjunction with the accompanying drawings in the embodiments of the present invention, and it will be apparent that the described embodiments are part of, but not all of, the embodiments of the present invention.

Based on the embodiments in the present invention, all other embodiments obtained by those of ordinary skill in the art without making creative efforts are within the scope of protection of the present invention.

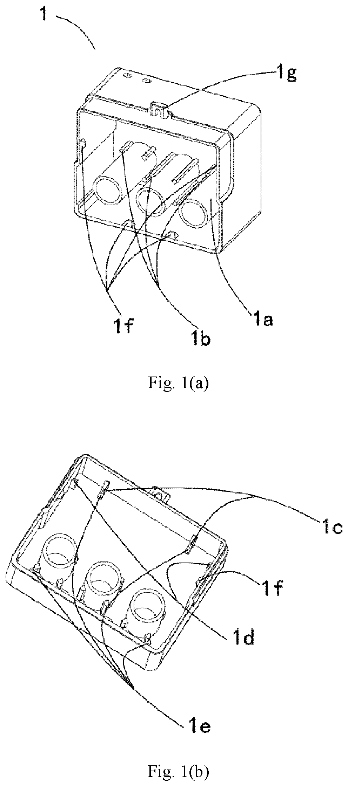

As shown in Figs. 1(a)-(b), an inner surface of the first housing 1 is provided with three tube bodies 1a arranged in a single line and on which transformer coils 4 are sleeved, an outer ring of the tube body 1a is provided with support ribs 1b for supporting the transformer coils 4 in a circumferential direction, guide ribs 1c are disposed on an upper side of an inner wall of the first housing 1, guide ribs 1d are disposed on both sides of the inner wall of the first housing 1 for installing a second circuit board 6, support ribs 1e are disposed at a bottom of the inner wall of the first housing 1 for supporting a first circuit board 5, four buckles 1f are disposed at an opening of the inner wall of the first housing 1 for fitting and fixing with a second housing 2, and a lead seal snap 1g is disposed on a top outside of the first housing 1.

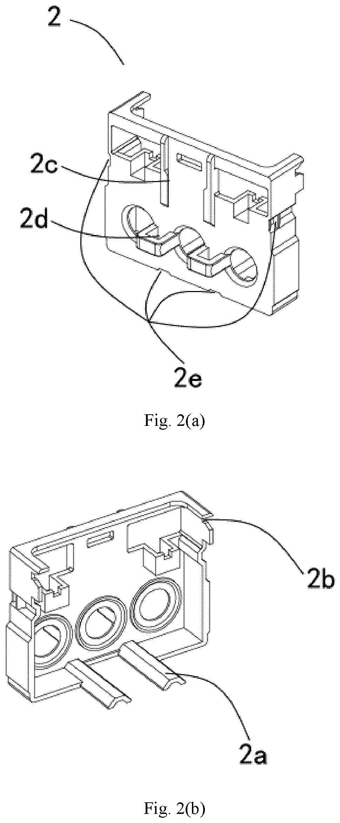

As shown in Figs. 2(a)-(b), a support post 2a is provided at an bottom of an inner side of the second housing 2 for supporting the first circuit board 5, a top of an inner side of the second housing 2 is provided with a snap groove 2b for fixing and positioning the second circuit board 6, a guide groove 2c is provided on an outer side of the second housing 2 for installing the protective cover 3, an outer side surface of the second housing 2 is provided with three through-holes for threading cables, and the outer side surface of the second housing 2 is provided with a tie buckle 2d between the adjacent two through-holes, the power monitoring apparatus can be fixed on the cables by fixing tools such as tie bands, and a side edge of the second housing 2 is provided with four buckle grooves 2e for fitting and fixing with the first housing 1.

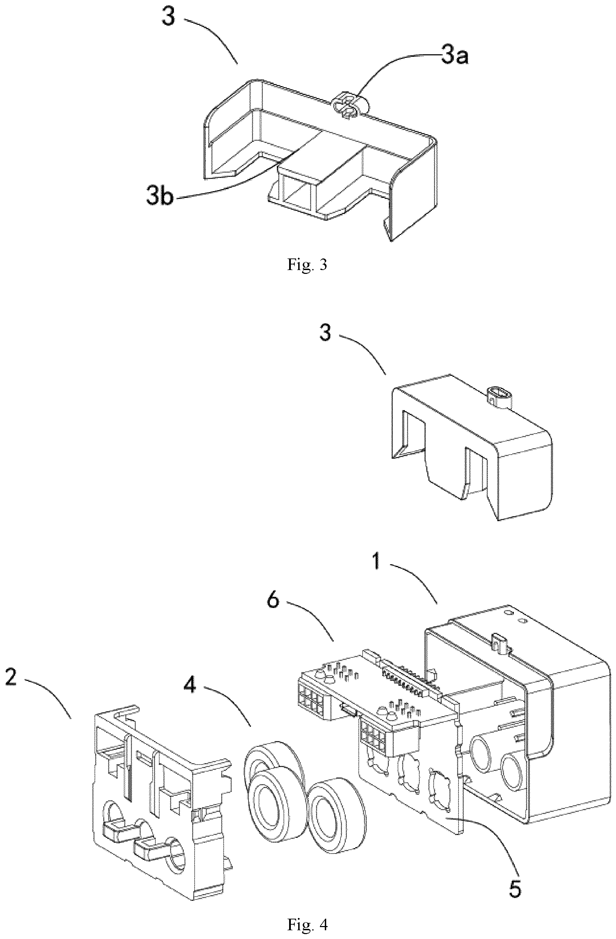

As shown in Fig. 3, a lead seal ring 3a is disposed on a top of the protective cover 3, the lead seal ring 3a is sleeved on the lead seal snap 1g above the first housing 1, and the lead seal ring 3a and the lead seal snap 1g are snap-connected together, and a guide rib 3b is disposed at an inner side of the protective cover 3 to fit with the guide groove 2c of the second housing 2.

As shown in Fig. 4, the part of the embodiment of the present invention is composed of the first housing 1, the second housing 2, the protective cover 3, the transformer coil 4, the first circuit board 5 and the second circuit board 6.

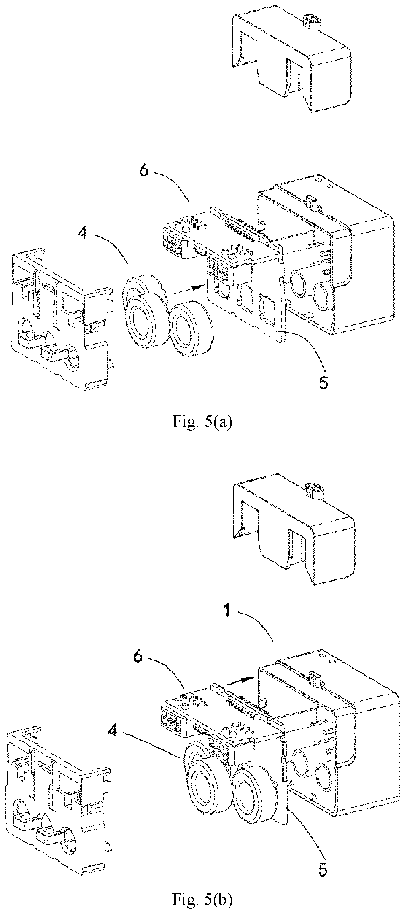

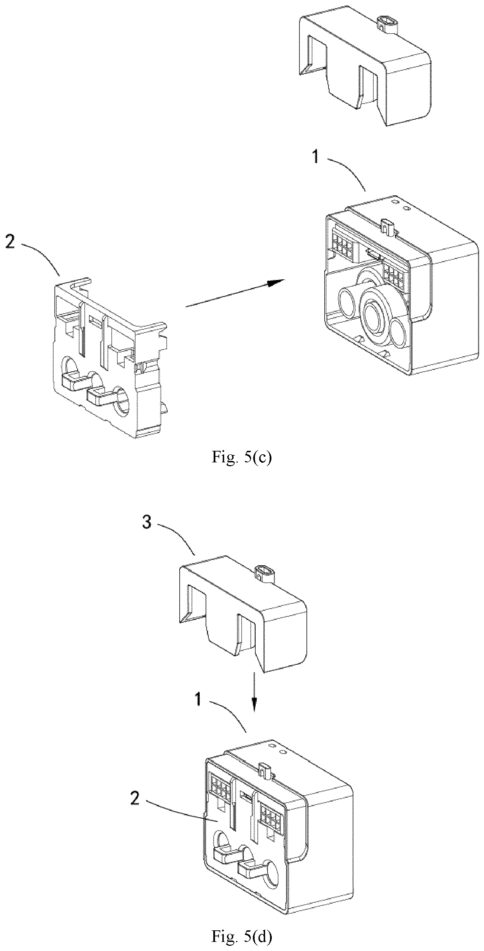

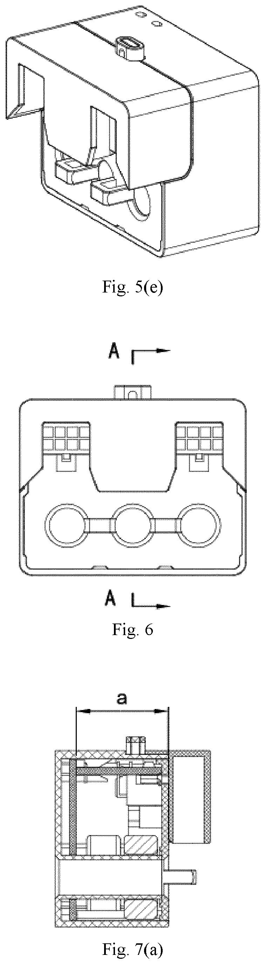

As shown in Fig. 5(a), the first circuit board 5 and the second circuit board 6 are electrically connected through a connector such as a pin, the first circuit board 5 and the second circuit board 6 are installed vertically to each other, the transformer coil 4 is installed to the first circuit board 5, the transformer coil 4 is electrically connected with the first circuit board 5 through a connecting line; as shown in Fig. 5(b), the transformer coil 4 is loaded into the first housing 1 together with the first circuit board 5 and the second circuit board 6; as shown in Fig. 5(c), the first circuit board 5 is provided with through-holes one-to-one corresponding to the tube bodies 1a, the through-holes of the first circuit board 5 and the transformer coil 4 are sequentially sleeved on the corresponding tube bodies 1a, the first circuit board 5 is installed on an inner surface of the first housing 1, the second circuit board 6 is installed on an inner side surface of the first housing 1, the second housing 2 is installed to the first housing 1, so that a main body of the power monitoring apparatus is assembled; as shown in Fig. 5(d), the protective cover 3 is installed to the main body of the power monitoring apparatus in the illustrated direction, the guide rib 3b is disposed inside the protective cover 3 and inserted into the guide groove 2c of the second housing 2, and a lead seal ring 3a is disposed above the protective cover 3 and sleeved on the lead seal snap 1g of the first housing 1 after the protective cover 3 is installed in place, as shown in Fig. 5(e) in conjunction with Figs. 2 and 3.

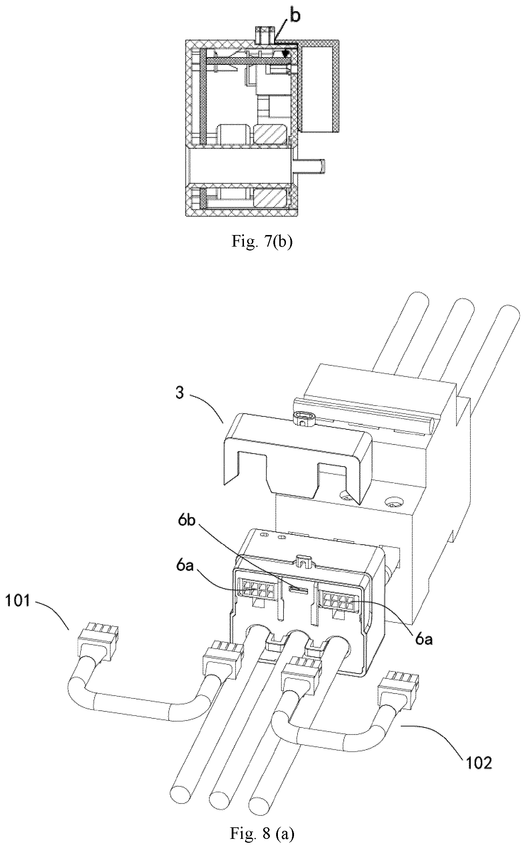

As shown in Fig. 6, it is a schematic front view of the power monitoring apparatus after installation is completed, where the protective cover covers the miniature USB interface 6b, as shown in Fig. 7(a), the first circuit board 5 is installed at the bottom of the first housing 1, there is an enough static discharge distance a to an assembling clearance between the first housing 1 and the second housing 2, which improves the safety. As shown in Fig. 7(b), the protective cover 3 increases a static discharge distance b inside and outside the electric quantity monitoring module.

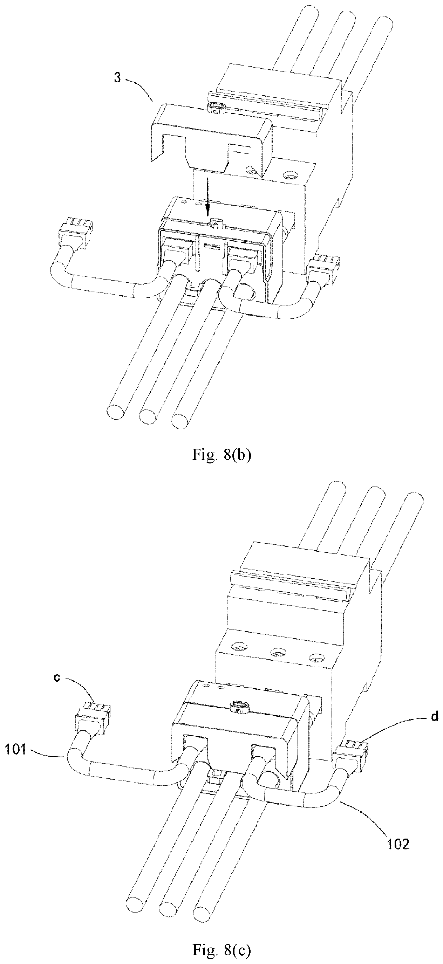

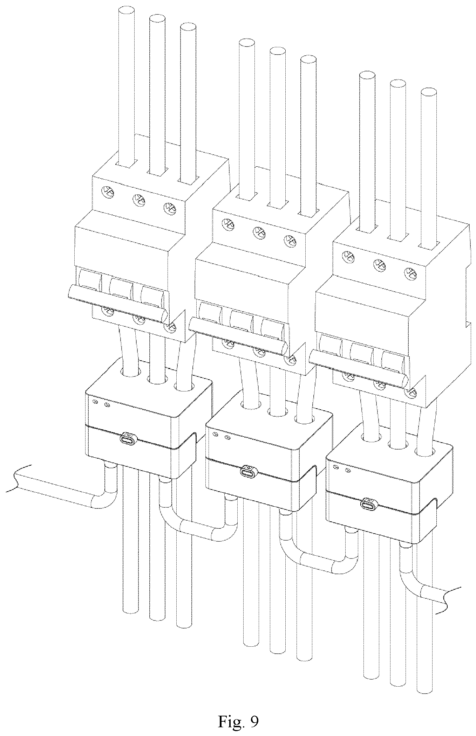

As shown in Fig. 8(a), the protective cover 3 is in an uninstalled state before wiring, where one ends of the connecting lines 101 and 102 are respectively inserted into the multi-port sockets 6a on both sides of the second circuit board 6, as shown in Fig. 8(b), after the connection is completed, the protective cover 3 is installed, a completion state is shown in Fig. 8(c), where the other ends c and d of the connecting lines 101 and 102 can continue to connect another power monitoring apparatus, as shown in Fig. 9.

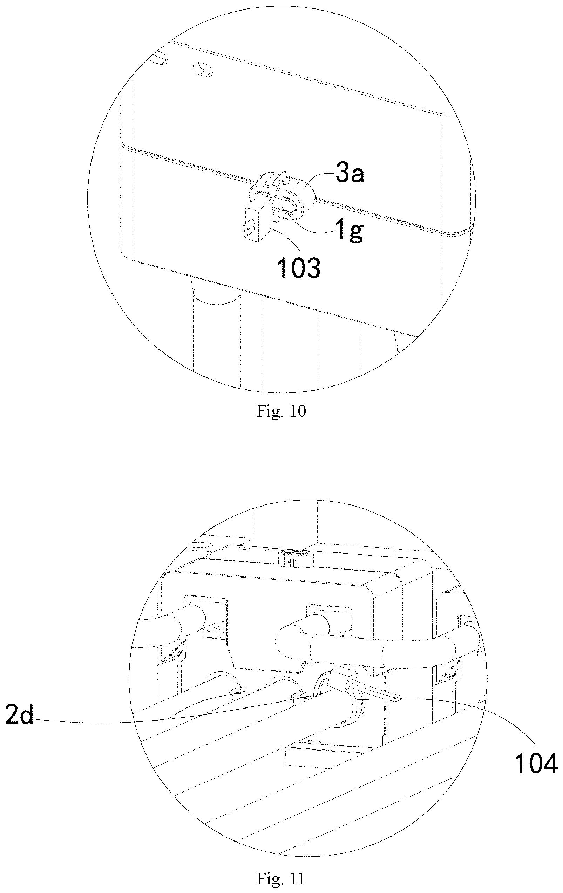

As shown in Fig. 10 and in conjunction with Fig. 6, the power monitoring apparatus can be sealed with a lead seal material 103 by the lead seal ring 3a of the protective cover 3 and the lead seal snap 1g above the first housing 1 to prevent plugging and unplugging of connecting line and changing firmware

As shown in Fig. 11, the power monitoring apparatus can be fixed on the cable through the front tie buckle 2d by using fixing tools such as tie bands 104, and the fixing pieces are convenient to obtain, low in cost and easy to operate during use.

While specific embodiments of the present invention have been described above, it will be understood by those skilled in the art that these are illustrative only and that the scope of the present invention is defined by the appended claims. Those skilled in the art may make various variations and modifications to these embodiments without departing from the principles and essence of the present invention, but such variations and modifications fall within the scope of the present invention.

## Claims

1. A power monitoring apparatus comprising a first housing, a second housing, a protective cover, a plurality of transformer coils, a first circuit board and a second circuit board, wherein
an inner surface of the first housing is provided with a plurality of tube bodies arranged in a single line, and an outside of a top of the first housing is provided with a lead seal snap;
a top of an inner side of the second housing is provided with a snap groove for fixing and positioning the second circuit board, an outer surface of the second housing is provided with a guide groove for installing the protective cover, and the outer surface of the second housing is provided with a plurality of through-holes one-to-one corresponding to the tube bodies for threading cables;
a top of the protective cover is provided with a lead seal ring mated with the lead seal snap, and an inner side of the protective cover is provided with a guide rib mated with a guide groove; and
the first circuit board and the second circuit board are electrically connected through a connector, the first circuit board and the second circuit board are installed vertically to each other, a transformer coil is installed on the first circuit board, the transformer coil is electrically connected to the first circuit board through a connecting line, the first circuit board is provided with the through-holes one-to-one corresponding to the tube bodies, the through-holes of the first circuit board and the transformer coil are sequentially sleeved on the corresponding tube bodies, the first circuit board is installed on the inner surface of the first housing, the second circuit board is installed on an inner side surface of the first housing, the second housing and the first housing are fixedly connected, the guide rib is inserted into the guide groove, the lead seal ring is sleeved on the lead seal snap, and the lead seal ring and the lead seal snap are snap-connected together.

2. The power monitoring apparatus of claim 1, wherein an outer ring of the tube body is provided with support ribs for supporting the transformer coils along a circumferential direction.

3. The power monitoring apparatus of claim 1, wherein a top of an inner wall of the first housing and upper portions of left and right sides of the inner wall are provided with the guide ribs for guiding the installed second circuit board.

4. The power monitoring apparatus of claim 1, wherein four support ribs for supporting the first circuit board are disposed at a bottom of the inner wall of the first housing.

5. The power monitoring apparatus of claim 1, wherein four buckles are disposed at an opening of the inner wall of the first housing, and four buckle grooves one-to-one corresponding to the buckles are disposed on a side edge of the second housing, and the buckles and corresponding buckle grooves are snap-connected.

6. The power monitoring apparatus of claim 1, wherein a bottom of an inner side of the second housing is provided with a support post for supporting the first circuit board.

7. The power monitoring apparatus of claim 1, wherein a tie buckle is disposed on an outer side surface of the second housing and between two adjacent through-holes.

8. The power monitoring apparatus of claim 1, wherein the second circuit board is provided with two identical multi-port sockets and one miniature USB interface.

9. The power monitoring apparatus of claim 1, wherein the lead seal ring is sleeved on the lead seal snap to form a lead seal structure, to allow a lead seal process to be implemented.

10. The power monitoring apparatus of claim 9, wherein the lead seal structure has a certain distance from an assembly position of the first housing and the second housing, to increase a static discharge distance inside and outside the power monitoring apparatus.
